# EUROPEAN PATENT SPECIFICATION

(11) **EP 4 002 965 B1**
(45) Date of publication and mention of the grant of the patent: **04.06.2025**
(21) Application number: 21209298.5
(22) Date of filing: 19.11.2021
(51) Int. Cl.: H05K 5/02, H05K 7/20, F24F 1/00

(54) **ELECTRIC CABINET AND AIR CONDITIONER**
SCHALTSCHRANK UND KLIMAANLAGE
ARMOIRE ÉLECTRIQUE ET CLIMATISEUR

(30) Priority: 23.11.2020 CN 202022732323 U
(43) Date of publication of application: 25.05.2022
(73) Proprietor: Guangdong Giwee Technology Co., Ltd., Foshan City Guangdong (CN)
(72) Inventor: LIU, Xueshu, Foshan City (CN)
(74) Representative: Dehns

(56) References cited:
- CN-U- 201 992 746
- CN-U- 207 118 139
- US-A- 6 053 808

## Description

The present invention relates to an electric cabinet.

With the development of electric cabinets of air conditioners in the direction of structural compactness and miniaturization, an electric cabinet will inevitably have the problem of heat dissipation. In order to strengthen heat dissipation, an efficient air duct will be designed at the top of an electric cabinet. However, all kinds of efficient air ducts are accompanied by the problem of air duct waterproofing and dustproofing. Existing electric cabinets usually ignore the waterproofing problem of air ducts while ensuring heat dissipation, which leads to water entering the electric cabinets, thus affecting the safety performance of the electric cabinets.

CN 207 118 139 U discloses an electric control box assembly including an air channel defined between a top of a box body of the electric control box and a rainproof cover. A diffuser plate is provided in the air channel adjacent to an open end of the air channel to divide the air channel into a plurality of sub-air ducts, thereby having both good rainproof effect and good ventilation effect.

The main objective of at least the example embodiments of the present invention is to provide an electric cabinet and an air conditioner to solve the problem of poor waterproof performance of existing electric cabinets.

The technical scheme of the present invention is as follows.

According to a first aspect there is provided an electric cabinet including a cabinet body, a ventilation cover, a top cover and a baffle. The ventilation cover is disposed at the top of the cabinet body, a ventilation hole is formed in the ventilation cover, the top cover is disposed above the ventilation cover and forms an air duct with one end open with the ventilation cover, the baffle covers an outlet of the air duct, an upper end of the baffle is connected with the top cover, a gap is formed between a lower end of the baffle and the ventilation cover, and the baffle is a shutter with the openings facing downward or a fender with a ventilation opening.

Optionally, the baffle includes an end plate and a cover plate, the end plate and the cover plate are fixedly connected at a specified angle, the end plate is attached to the top cover and is fixedly connected with the top cover, the cover plate is disposed at the outlet of the air duct, and the ventilation opening is formed in the cover plate.

Optionally, the ventilation opening is circular or square.

Optionally, the cabinet body further includes a bottom plate, and an air inlet is formed in the bottom plate.

Optionally, the ventilation cover includes a platform part and a first bulge part, the first bulge part is higher than the platform part, the ventilation hole is formed in the first bulge part, and the platform part is close to the outlet of the air duct.

Optionally, the top cover includes a flat plate part and a second bulge part, the second bulge part is higher than the flat plate part, the flat plate part is located above the platform part, the second bulge part is located above the first bulge part, and the air duct is formed between the first bulge part as well as the platform part and the second bulge part as well as the flat plate part.

Optionally, a top wall of the second bulge part is tilted downwardly in a direction away from the outlet of the air duct.

Optionally, the top cover further includes a mounting plate for mounting the electric cabinet at a predetermined mounting position, the mounting plate is arranged on a side of the second bulge part facing away from the flat plate part, the mounting plate is connected with the second bulge part, the thickness of the mounting plate is greater than the thickness of the second bulge part, and a water guiding groove is formed at a joint between the mounting plate and the second bulge part.

Viewed from another aspect, the present invention further provides an air conditioner including the above-mentioned electric cabinet.

The present invention hence may provide an electric cabinet and an air conditioner including the electric cabinet. The electric cabinet includes a cabinet body, a ventilation cover, a top cover, and a baffle; the ventilation cover is disposed at the top of the cabinet body; a ventilation hole is formed in the ventilation cover; the top cover is disposed above the ventilation cover and forms an air duct with one end open with the ventilation cover; the baffle covers an outlet of the air duct; an upper end of the baffle is connected with the top cover; a gap is formed between a lower end of the baffle and the ventilation cover; and the baffle is a shutter with the openings facing downward or a fender with a ventilation opening. By arranging the baffle at the outlet of the air duct, it is possible to effectively stop rainwater from entering the air duct, while at the same time, an opening or ventilation opening is formed in the baffle for ventilation and heat dissipation. The electric cabinet of at least the preferred embodiments guarantees good heat dissipation effect, has good waterproofing function, and is simple in structure and strong in practicability.

Certain exemplary embodiments will now be described in greater detail by way of example only and with reference to the accompanying drawings in which:
Fig. 1 is an exploded view of an electric cabinet;
Fig. 2 is a schematic diagram of assembly of an electric cabinet;
Fig. 3 is a partial view of a cross-sectional view along a line A-A in Fig. 2;
Fig. 4 is a partial enlarged view of M area in Fig. 3; and
Fig. 5 is a schematic structural diagram of an alternative electric cabinet.

The implementation, functional characteristics, and advantages of the present invention will be further described in combination with the embodiments and with reference to the accompanying drawings.

It is necessary to understand that orientation or positional relationship indicated by the terms "center," "longitudinal," "transverse," "length," " width," "thickness," "upper," "lower," "front," "rear," "left," "right," "vertical," "horizontal," "top," "bottom," "inner," "outer," "clockwise," and "anticlockwise" is based on the orientation or positional relationship shown in the drawings, which is only for the convenience of simplifying the description, rather than indicating or implying that the device or element referred to must have a specific orientation or be constructed and operated in a specific orientation. In addition, the terms "first" and "second" are only used for descriptive purposes and cannot be understood as indicating or implying relative importance or implicitly indicating the number of indicated technical features. Thus, the features defined by "first" and "second" may explicitly or implicitly include one or more of the features. As used herein, "a plurality of" means two or more, unless specifically defined otherwise.

It should be noted that, unless otherwise clearly specified and limited, the terms "install," "connect," and "link" should be understood in a broad sense. For example, it may be a fixed connection, a detachable connection, or an integral connection; it may be a mechanical connection, a direct connection, or an indirect connection through an intermediate medium. The connection may be the internal communication between two elements or the interaction relationship between the two elements. For those of ordinary skill in the art, the specific meaning of the above-mentioned terms can be understood according to specific circumstances.

In the present document, unless otherwise clearly specified and limited, a first feature being "on" or "under" a second feature may include that the first feature and the second feature are in direct contact, and may include that the first feature and the second feature are not in direct contact but are in contact through an additional feature between them. Further, the first feature being "on," "above," or "over" the second feature includes that the first feature is directly above and obliquely above the second feature, or only means that the horizontal height of the first feature is larger than that of the second feature. The first feature being "under," "below," or "beneath" the second feature includes that the first feature is directly below and obliquely below the second feature, or only means that the horizontal height of the first feature is smaller than that of the second feature.

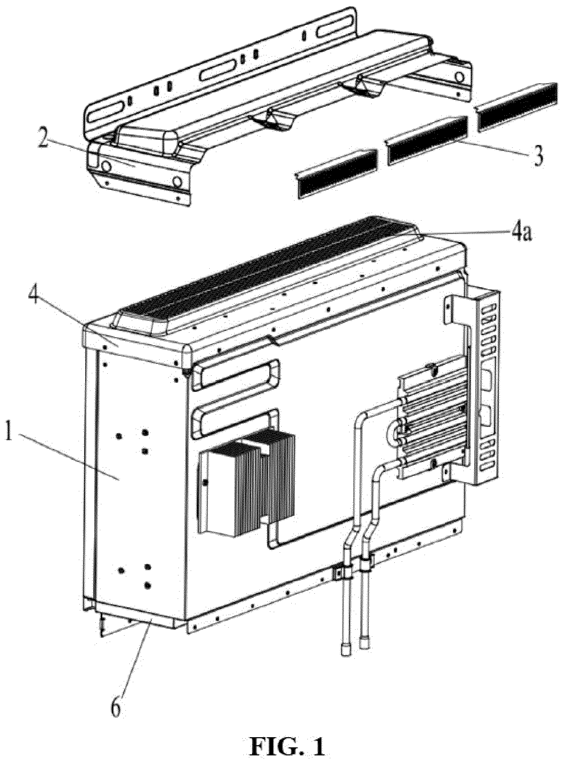

Referring to Figs. 1, 2, and 3, an electric cabinet includes cabinet body 1, top cover 2, baffle 3, and ventilation cover 4. Ventilation cover 4 is disposed at the top of cabinet body 1, ventilation hole 4a is formed in ventilation cover 4, top cover 2 is disposed above ventilation cover 4 and forms air duct 5 with one end open with ventilation cover 4, baffle 3 covers an outlet of air duct 5, an upper end of baffle 3 is connected with top cover 2, and baffle 3 is a shutter with the openings facing downward or a fender with a ventilation opening.

Various types of electronic components are installed in cabinet body 1, ventilation cover 4 is disposed at the top of cabinet body 1, ventilation cover 4 is detachably fixed at the top of cabinet body 1, ventilation hole 4a is formed in ventilation cover 4, and ventilation hole 4a is configured to take out heat generated by the electronic components in cabinet body 1 when working. Top cover 2 is disposed on ventilation cover 4, top cover 2 is fixed above ventilation cover 4, a space is reserved between top cover 2 and ventilation cover 4, and the space forms air duct 5 for ventilation and heat dissipation of the electric cabinet. Ventilation hole 4a is located in air duct 5, and the heat inside cabinet body 1 enters air duct 5 through ventilation hole 4a and then is dissipated to the outside of cabinet body 1 through the outlet of air duct 5. Top cover 2 is disposed above ventilation cover 4, which may prevent rainwater from directly entering cabinet body 1 through ventilation hole 4a from top to bottom.

In the arrangement of the Figures, baffle 3 is arranged at the outlet of air duct 5, which effectively stops rainwater from entering air duct 5, and at the same time, baffle 3 is provided with an opening or a ventilation opening for ventilation and heat dissipation. The electric cabinet has a good waterproofing function on the basis of a good heat dissipation effect, and it is simple in structure and strong in practicability.

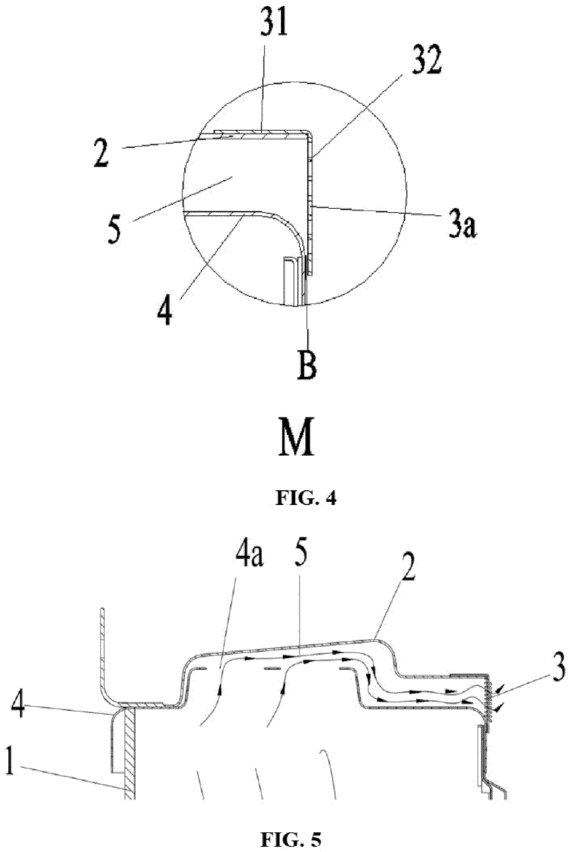

Referring to Fig. 4, baffle 3 is a fender with ventilation openings, the fender is in an L shape, and includes end plate 31 and cover plate 32. End plate 31 and cover plate 32 are fixedly connected at a specified angle, end plate 31 is attached to top cover 2 and is fixedly connected with top cover 2, cover plate 32 is arranged at the outlet of air duct 5, cover plate 32 is provided with a plurality of through holes 3a, and through holes 3a are the ventilation openings mentioned above.

The specified angle may be 90 degrees, or other angles can be designed according to actual needs, so that baffle 3 can well cover the outlet of air duct 5. In the embodiment, a plurality of through holes 3a are arranged and are evenly distributed on cover plate 32. In the embodiment, a large number of through holes 3a are designed to have a relatively small structure, and they are densely distributed on cover plate 32. The small shape of through holes 3a may effectively prevent rainwater from entering air duct 5 via through holes 3a. At the same time, the number of through holes 3a is large, and they are densely distributed on cover plate 32, which may guarantee a ventilation area coverage rate of baffle 3, guarantee ventilation and heat dissipation functions of baffle 3, and ensure that the heat in cabinet body 1 can be effectively dissipated from baffle 3 to the outside after passing through air duct 5. The through holes 3a may be designed in a circular shape, a square shape, an oval shape, and the like.

With reference to Fig. 5, baffle 3 is a shutter structure with the openings facing downward. The shutter structure with the openings facing downward may also effectively stop rainwater from entering air duct 5, and the heat in cabinet body 1 can be dissipated to the outside from the openings between slats of the shutter after passing through air duct 5.

With reference to Figs. 4 and 5, a gap B is formed between a lower end of baffle 3 and ventilation cover 4. When a small part of rainwater splashes into through holes 3a or the openings of the shutter and enters air duct 5, it falls onto ventilation cover 4 and then flows out through the gap B. The setting of the gap B may prevent water from accumulating between ventilation cover 4 and baffle 3 and from causing corrosion.

With reference to Fig. 1, cabinet body 1 further includes bottom plate 6, and bottom plate 6 is provided with an air inlet (not shown). The air inlet is arranged on bottom plate 6. It can be seen that a heat dissipation channel of the electric cabinet is: from bottom plate 6 to the inside of cabinet body 1 to ventilation cover 4 to air duct 5 and to baffle 3. The heat dissipation channel of the electric cabinet covers all corners inside cabinet body 1 from bottom to top. External air enters the inside of cabinet body 1 from the air inlet on bottom plate 6 to take away the heat in the corners of cabinet body 1, then exits from ventilation hole 4a in ventilation cover 4, and is dissipated to the outside of cabinet body 1 through air duct 5 and through holes 3a or openings on baffle 3. The bottom-up heat dissipation channel can effectively take away most of the heat inside cabinet body 1, so that the electric cabinet has a good heat dissipation function.

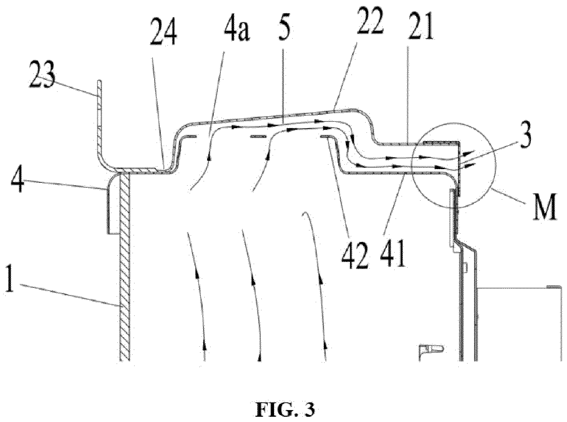

With reference to Fig. 3, ventilation cover 4 includes platform part 41 and first bulge part 42, first bulge part 42 is higher than platform part 41, ventilation hole 4a is formed in first bulge part 42, and platform part 41 is close to the outlet of air duct 5. In this way, when external rainwater enters air duct 21, first bulge part 42 may block the rainwater to prevent the rainwater from flowing into ventilation hole 4a along the top wall of ventilation cover 4, thus achieving a better rainproof effect.

With reference to Fig. 3, top cover 2 includes flat plate part 21 and second bulge part 22, second bulge part 22 is higher than flat plate part 21, flat plate part 21 is located above platform part 41, second bulge part 22 is located above first bulge part 42, and air duct 5 is formed between first bulge part 42 as well as platform part 41 and second bulge part 22 as well as flat plate part 21. It can be seen that top cover 2 and ventilation cover 4 are structurally matched with each other, which facilitates the formation of air duct 5. A horizontal length of second bulge part 22 is greater than a horizontal length of first bulge part 42, to prevent ventilation cover 4 and top cover 2 from forming a narrow passage in air duct 5 due to bulges. With reference to Fig. 3, the structure of air duct 5 is roughly in a "Z" shape, so that air flow in air duct 5 is smoother, and the heat dissipation effect of the components inside cabinet body 1 may be better.

A top wall of second bulge part 22 is tilted downwardly in a direction away from the outlet of air duct 5. In special high-humidity weather, a small amount of dew will condense on an inner surface of top cover 2. By making the top wall of second bulge part 22 into a slope shape, the dew may flow along the inclined slope after condensing on a lower surface of the top wall of second bulge part 22, so the dew is prevented from falling into ventilation hole 4a and from causing water to enter the inside of cabinet body 1. At the same time, this design has the least impact on the ventilation resistance, that is, after the heat inside cabinet body 1 is discharged from ventilation hole 4a, it may flow along the top wall slope of second bulge part 22 to the outlet of air duct 5, and the flowing effect is smooth.

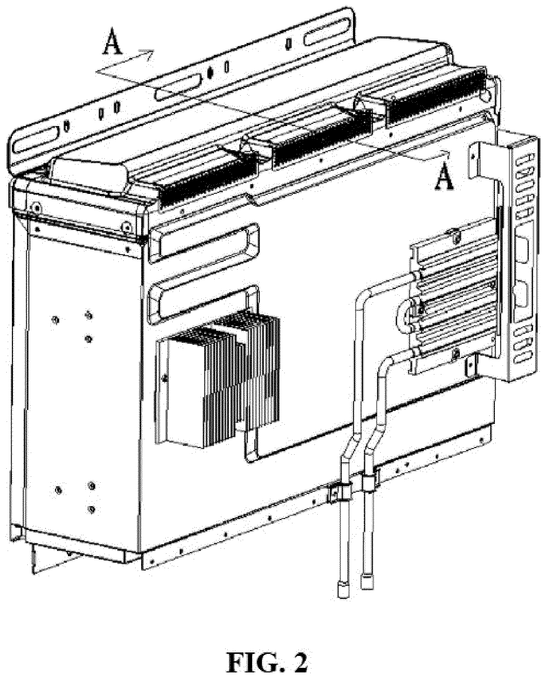

With reference to Figs. 2 and 3 top cover 2 further includes mounting plate 23 for mounting the electric cabinet at a predetermined mounting position. Mounting plate 23 is arranged on a side of second bulge part 22 facing away from flat plate part 21, mounting plate 23 is connected with second bulge part 22, the thickness of mounting plate 23 is greater than the thickness of second bulge part 22, and water guiding groove 24 is formed at a joint between mounting plate 23 and second bulge part 22.

The electric cabinet is fixedly mounted at a designated position by top cover 2 through mounting plate 23. Mounting plate 23 is provided with penetrating holes for bolts to pass through for fixing. The thickness of mounting plate 23 is relatively larger than other positions of top cover 2 (for example, second bulge part 22 and flat plate part 21), which increases the strength of mounting plate 23 and ensures the mounting stability of the electric cabinet. At the same time, water guiding groove 24 is arranged at the joint between mounting plate 23 and second bulge part 22, so that the rainwater flowing down from an upper surface of tilted second bulge part 22 may be discharged through water guiding groove 24 to prevent water accumulation between mounting plate 23 and second bulge part 22.

With reference to Figs. 1 and 2 top cover 2 and ventilation cover 4 define three mutually spaced air ducts 5, and one outlet of each air duct 5 is provided with baffle 3. Alternatively, the number of air ducts 5 may be designed according to user requirements, and hence it may differ from three.

An air conditioner can be provided, where the air conditioner includes the above-mentioned electric cabinet. Since the above-mentioned electric cabinet has the above advantages, the air conditioner provided with the above-mentioned electric cabinet has corresponding advantages. Therefore, the air conditioner has good heat dissipation function and waterproofing function, and is low in maintenance cost and strong in practicability.

By arranging baffle 3 at the outlet of air duct 5, the electric cabinet effectively prevents rainwater from entering air duct 5. At the same time, baffle 3 is provided with the ventilation hole for ventilation and heat dissipation. On the basis of ensuring ventilation and heat dissipation, the electric cabinet solves the problem of rainproof function, is not easy to cause water accumulation, has a simple structure, is low in maintenance cost, and has a wide application prospect.

The above description is only concerned with preferred embodiments of the present invention, and does not limit the scope of the present invention, which is instead as defined by the appended claims.

## Claims

1. An electric cabinet, comprising a cabinet body (1), a ventilation cover (4), and a top cover (2), wherein the ventilation cover (4) is disposed at the top of the cabinet body (1), and a ventilation hole (4a) is formed in the ventilation cover (4); and the top cover (2) is disposed above the ventilation cover (4) and forms an air duct (5) with one end open with the ventilation cover (4);
**characterised by** a baffle (3), wherein the baffle (3) covers an outlet of the air duct (5), an upper end of the baffle (3) is connected with the top cover (2), a gap (B) is formed between a lower end of the baffle (3) and the ventilation cover (4), and the baffle (3) is a shutter with the openings facing downward or a fender with a ventilation opening.

2. The electric cabinet according to claim 1, wherein the baffle (3) comprises an end plate (31) and a cover plate (32); the end plate (31) and the cover plate (32) are fixedly connected at a specified angle; the end plate (31) is attached to the top cover (2) and is fixedly connected with the top cover (2); and the cover plate (32) is disposed at the outlet of the air duct (5), and the ventilation opening is formed in the cover plate.

3. The electric cabinet according to claim 1 or 2, wherein the ventilation opening is circular or square.

4. The electric cabinet according to any preceding claim, wherein the cabinet body (1) comprises a bottom plate (6), and an air inlet is formed in the bottom plate (6).

5. The electric cabinet according to any preceding claim, wherein the ventilation cover (4) comprises a platform part (41) and a first bulge part (42), the first bulge (42) part is higher than the platform part (41), and the ventilation hole (4a) is formed in the first bulge part (42); and the platform part (41) is close to the outlet of the air duct (5).

6. The electric cabinet according to claim 5, wherein the top cover (2) comprises a flat plate part (21) and a second bulge part (22), and the second bulge part (22) is higher than the flat plate part (21); the flat plate part (21) is located above the platform part (41), and the second bulge part (22) is located above the first bulge part (42); and the air duct (5) is formed between the first bulge part (42) as well as the platform part (41) and the second bulge part (22) as well as the flat plate part (21).

7. The electric cabinet according to claim 6, wherein a top wall of the second bulge part (22) is tilted downwardly in a direction away from the outlet of the air duct (5).

8. The electric cabinet according to claim 6 or 7, wherein the top cover (2) comprises a mounting plate (23) for mounting the electric cabinet at a predetermined mounting position; the mounting plate (23) is arranged on a side of the second bulge part (22) facing away from the flat plate part (21); the mounting plate (23) is connected with the second bulge part (22); and the thickness of the mounting plate (23) is greater than the thickness of the second bulge part (22), and a water guiding groove (24) is formed at a joint between the mounting plate (23) and the second bulge part (22).

9. An air conditioner comprising the electric cabinet according to any preceding claim.

## Patentansprüche

1. Elektroschrank, umfassend einen Schrankkörper (1), eine Lüftungsabdeckung (4) und eine obere Abdeckung (2), wobei die Lüftungsabdeckung (4) an der Oberseite des Schrankkörpers (1) angeordnet ist und in der Lüftungsabdeckung (4) ein Lüftungsloch (4a) gebildet ist; und die obere Abdeckung (2) über der Lüftungsabdeckung (4) angeordnet ist und einen Luftkanal (5) bildet, dessen eines Ende zu der Lüftungsabdeckung (4) hin offen ist;
**gekennzeichnet durch** eine Ablenkplatte (3), wobei die Ablenkplatte (3) einen Auslass des Luftkanals (5) abdeckt, ein oberes Ende der Ablenkplatte (3) mit der oberen Abdeckung (2) verbunden ist, ein Spalt (B) zwischen einem unteren Ende der Ablenkplatte (3) und der Lüftungsabdeckung (4) gebildet ist und die Ablenkplatte (3) ein Verschluss mit nach unten gerichteten Öffnungen oder ein Schutzblech mit einer Lüftungsöffnung ist.

2. Elektroschrank nach Anspruch 1, wobei die Ablenkplatte (3) eine Endplatte (31) und eine Abdeckplatte (32) umfasst; die Endplatte (31) und die Abdeckplatte (32) in einem bestimmten Winkel fest miteinander verbunden sind; die Endplatte (31) an der oberen Abdeckung (2) angebracht und fest mit der oberen Abdeckung (2) verbunden ist; und die Abdeckplatte (32) an dem Auslass des Luftkanals (5) angeordnet ist und die Lüftungsöffnung in der Abdeckplatte gebildet ist.

3. Elektroschrank nach Anspruch 1 oder 2, wobei die Lüftungsöffnung kreisförmig oder quadratisch ist.

4. Elektroschrank nach einem der vorhergehenden Ansprüche, wobei der Schrankkörper (1) eine Bodenplatte (6) umfasst und ein Lufteinlass in der Bodenplatte (6) gebildet ist.

5. Elektroschrank nach einem der vorhergehenden Ansprüche, wobei die Lüftungsabdeckung (4) ein Plattformteil (41) und ein erstes Ausbuchtungsteil (42) umfasst, wobei das erste Ausbuchtungsteil (42) höher als das Plattformteil (41) ist und das Lüftungsloch (4a) in dem ersten Ausbuchtungsteil (42) gebildet ist; und wobei das Plattformteil (41) nahe dem Auslass des Luftkanals (5) ist.

6. Elektroschrank nach Anspruch 5, wobei die obere Abdeckung (2) ein flaches Plattenteil (21) und ein zweites Ausbuchtungsteil (22) umfasst und das zweite Ausbuchtungsteil (22) höher als das flache Plattenteil (21) ist; sich das flache Plattenteil (21) über dem Plattformteil (41) befindet und sich das zweite Ausbuchtungsteil (22) über dem ersten Ausbuchtungsteil (42) befindet; und der Luftkanal (5) zwischen dem ersten Ausbuchtungsteil (42) sowie dem Plattformteil (41) und dem zweiten Ausbuchtungsteil (22) sowie dem flachen Plattenteil (21) gebildet ist.

7. Elektroschrank nach Anspruch 6, wobei die obere Wand des zweiten Ausbuchtungsteils (22) in Richtung von dem Auslass des Luftkanals (5) weg nach unten geneigt ist.

8. Elektroschrank nach Anspruch 6 oder 7, wobei die obere Abdeckung (2) eine Montageplatte (23) zum Montieren des Elektroschranks an einer vorbestimmten Montageposition umfasst; die Montageplatte (23) auf einer Seite des zweiten Ausbuchtungsteils (22) angeordnet ist, die von dem flachen Plattenteil (21) abgewandt ist; die Montageplatte (23) mit dem zweiten Ausbuchtungsteil (22) verbunden ist; und die Dicke der Montageplatte (23) größer ist als die Dicke des zweiten Ausbuchtungsteils (22), und eine Wasserführungsnut (24) an einer Verbindung zwischen der Montageplatte (23) und dem zweiten Ausbuchtungsteil (22) gebildet ist.

9. Klimaanlage, umfassend einen Elektroschrank nach einem der vorhergehenden Ansprüche.

## Revendications

1. Armoire électrique, comprenant un corps d'armoire (1), un capot de ventilation (4) et un capot supérieur (2), dans laquelle le capot de ventilation (4) est disposé au sommet du corps d'armoire (1) et un orifice de ventilation (4a) est formé dans le capot de ventilation (4) ; et le capot supérieur (2) est disposé au-dessus du capot de ventilation (4) et forme un conduit d'air (5) dont une extrémité est ouverte par le capot de ventilation (4) ;
**caractérisé par** un déflecteur (3), dans laquelle le déflecteur (3) recouvre une sortie du conduit d'air (5), une extrémité supérieure du déflecteur (3) est reliée au couvercle supérieur (2), un espace (B) est formé entre une extrémité inférieure du déflecteur (3) et le couvercle de ventilation (4), et le déflecteur (3) est un obturateur avec les ouvertures orientées vers le bas ou un garde-boue avec une ouverture de ventilation.

2. Armoire électrique selon la revendication 1, dans laquelle le déflecteur (3) comprend une plaque d'extrémité (31) et une plaque de recouvrement (32) ; la plaque d'extrémité (31) et la plaque de recouvrement (32) sont reliées de manière fixe au niveau d'un angle spécifié ; la plaque d'extrémité (31) est fixée au couvercle supérieur (2) et est reliée de manière fixe au couvercle supérieur (2) ; et la plaque de recouvrement (32) est disposée au niveau de la sortie du conduit d'air (5), et l'ouverture de ventilation est formée dans la plaque de recouvrement.

3. Armoire électrique selon la revendication 1 ou 2, dans laquelle l'ouverture de ventilation est circulaire ou carrée.

4. Armoire électrique selon une quelconque revendication précédente, dans laquelle le corps d'armoire (1) comprend une plaque inférieure (6), et une entrée d'air est formée dans la plaque inférieure (6).

5. Armoire électrique selon une quelconque revendication précédente, dans laquelle le couvercle de ventilation (4) comprend une partie plate-forme (41) et une première partie renflée (42), la première partie renflée (42) est plus haute que la partie plate-forme (41), et le trou de ventilation (4a) est formé dans la première partie renflée (42) ; et la partie plate-forme (41) est proche de la sortie du conduit d'air (5).

6. Armoire électrique selon la revendication 5, dans laquelle le couvercle supérieur (2) comprend une partie de plaque plate (21) et une seconde partie renflée (22), la seconde partie renflée (22) est plus haute que la partie de plaque plate (21) ; la partie de plaque plate (21) est située au-dessus de la partie de plate-forme (41), et la seconde partie renflée (22) est située au-dessus de la première partie renflée (42) ; et le conduit d'air (5) est formé entre la première partie renflée (42) ainsi que la partie de plate-forme (41) et la seconde partie de renflement (22) ainsi que la partie de plaque plate (21).

7. Armoire électrique selon la revendication 6, dans laquelle une paroi supérieure de la seconde partie renflée (22) est inclinée vers le bas dans une direction s'éloignant de la sortie du conduit d'air (5).

8. Armoire électrique selon la revendication 6 ou 7, dans laquelle le couvercle supérieur (2) comprend une plaque de montage (23) pour le montage de l'armoire électrique au niveau d'une position de montage prédéterminée ; la plaque de montage (23) est disposée sur un côté de la seconde partie renflée (22) opposé à la partie plate (21) ; la plaque de montage (23) est reliée à la seconde partie renflée (22) ; et l'épaisseur de la plaque de montage (23) est supérieure à l'épaisseur de la seconde partie renflée (22), et une rainure de guidage d'eau (24) est formée au niveau d'un joint entre la plaque de montage (23) et la seconde partie renflée (22).

9. Climatiseur comprenant l'armoire électrique selon une quelconque revendication précédente.
